Europäisches Patentamt

(19) European Patent Office

Office européen des brevets

(11) Publication number: **0 081 396**
A2

(12) # EUROPEAN PATENT APPLICATION

(21) Application number: 82401907.9

(22) Date of filing: 18.10.82

(51) Int. Cl.³: **H 01 L 29/80**
H 01 L 29/52, H 01 L 29/60

(30) Priority: 04.12.81 US 327659

(43) Date of publication of application:
15.06.83 Bulletin 83/24

(84) Designated Contracting States:
BE CH DE FR GB IT LI NL SE

(71) Applicant: NATIONAL AERONAUTICS AND SPACE
ADMINISTRATION
NASA Headquarters
Washington, D.C. 20546(US)

(72) Inventor: Ho, Chung Huang
11 Stonelea Drive
Princeton New Jersey 08550(US)

(74) Representative: Hirsch, Marc-Roger
34 rue de Bassano
F-75008 Paris(FR)

(54) **Microwave field effect transistor.**

(57) Electrodes of a high power, microwave field effect transistor are substantially matched to external input and output networks. The field effect transistor includes a metal ground plane layer, a dielectric layer on the ground plane layer, a gallium arsenide active region on the dielectric layer, and substantially coplanar spaced source, gate and drain electrodes having active segments covering the active region. The active segment of the gate electrode is located between edges of the active segment of the source electrodes. The gate and drain electrodes include inactive pads remote from the active segments thereof. The pads are connected directly to the input and output networks. The source electrode is connected to the ground plane layer. The space between the electrodes and the geometry of the electrodes establish parasitic shunt capacitances and series inductances that provide substantial matches between the input network and the gate electrode and between the output network and the drain electrode. Many of the devices are connected in parallel and share a common active region, so that each pair of adjacent devices shares the same source electrodes and each pair of adjacent devices shares the same drain electrodes. The gate electrodes for the parallel devices are formed by a continuous stripe that extends between adjacent devices and is connected at different points to the common gate pad.

FIG.1

# MICROWAVE FIELD EFFECT TRANSISTOR

## TECHNICAL FIELD:

The present invention relates generally to high power, microwave field effect transistors, and more particularly to a high power, microwave field effect transistor in which spacing between electrodes and electrode geometry establish parasitic shunt capacitances and series inductances that provide substantial matches between the electrodes and input and output networks for the field effect transistor. In accordance with another aspect, the invention is directed to a high power, microwave field effect transistor formed of a plurality of parallel field effect devices having a gate electrode formed by a continuous stripe that extends between adjacent ones of the devices.

## BACKGROUND ART:

It is highly desirable in numerous communications applications to achieve output power of the order of two to ten watts in the microwave frequency range of 12 to 20 gigaHertz (GHz) from a gallium arsenide (GaAs) field effect transistor (FET). It is believed that these performance requirements are beyond the present state of the art. One of the reasons why such high power has not been attained in the stated frequency range is the low impedance of GaAs FETs, in particular the relatively low shunt impedance of the GaAs active region. The impedance of the GaAs FET is to be contrasted with the standard impedance of 50 ohms of sources and loads which drive and are driven by the GaAs FETs via input and output networks that generally have a 50 ohm characteristic impedance. The differences in the impedance of the GaAs FET and the characteristic impedances of the input and output networks connected to the FET cause substantial mismatches. The mismatches are overcome by impedance matching networks that are connected between the input and output networks and a gate (input) electrode of the FET and one of a drain or source (output) electrode of the FET. The matching networks insert substantial losses and reduce the output power of the device. Impedance matching networks also frequently have dimensions such that terminals thereof are more than one wavelength away from an active region of the GaAs FET. Such a situation causes a substantial portion of the available microwave power from the source or amplified by the GaAs FET to be dissipated in a resistive component of the impedance matching networks. Because of these factors, the microwave output power and power gain of the GaAs FET are considerably reduced from the theoretical capability of the GaAs FET.

It is, however, necessary for an impedance match to exist between the GaAs FET and the source and load to which it is connected. Otherwise, a standing wave pattern is developed that causes a substantial loss in microwave power. There are also substantial losses in microwave power because of the finite resistance in transmission lines connecting the GaAs FET device to the source and load. For microwave, high power GaAs FET's, the losses in input and output impedance matching networks connected between the microwave source and load and the active device can be so high as to render the apparent performance of the GaAs FET considerably lower than the intrinsic performance of the GaAs FET.

It is, accordingly, an object of the present invention to provide a new and improved high power, microwave FET.

**0081396**

Another object of the invention is to provide a new and improved, high power, microwave GaAs FET that is matched to sources and loads having standard impedance.

A further object of the invention is to provide a new and improved high power, microwave GaAs FET that is designed so that the need for matching networks between the FET and a microwave source and microwave load is substantially obviated.

A further object of the invention is to provide a new and improved microwave, high power GaAs FET that is designed so that it is substantially matched to a source and load, whereby the need for power dissipating impedance matching networks is substantially obviated.

Still another object of the invention is to provide a new and improved high power, microwave FET that is connected directly to a source and a load, each having standard impedances, by way of internal matching networks having dimensions less than one wavelength.

THE INVENTION:

In accordance with the present invention, a new and improved, high power, microwave GaAs FET minimizes losses in impedance matching networks and inactive zones (electrode segments that are not superimposed on an active region) of the FET by limiting the total active area of each unit cell of the FET and by matching or partially matching the impedances of each unit cell to the source and load if a plurality of unit cells are combined in a single device having the usual external source, drain and gate electrodes.

To minimize losses in the inactive zones of each device, matching networks are physically located immediately adjacent the GaAs active region of the high power, microwave GaAs FET and are actually part of the FET electrodes. By placing the matching networks within the device and immediately adjacent the active region, the area and therefore losses of the inactive zone are minimized.

In particular, the device includes a metal ground plane layer, a dielectric layer on the ground plane layer, and a gallium arsenide active region on the dielectric layer. Substantially co-planar spaced source, gate and drain electrodes have active segments covering and connected to the active region so that the active segment of the gate electrode is located between the active segments of the source and drain electrodes. Each of the electrodes includes an inactive segment that does not overlay the active region. The impedance of the GaAs active region is substantially less than the characteristic impedance of input and output networks that are respectively connected to the gate electrode and one of the source or drain electrodes. The inactive segment of the gate electrode includes a pad remote from the portion thereof located between the edges of the source and drain electrodes. The gate pad is adapted to be connected to the input network, preferably without the use of a wire lead which is likely to result in resistive losses as well as mismatching due to the inductance thereof. The inactive segment of one of the other electrodes, i.e., either the source or drain electrode (the drain electrode in the preferred embodiment), includes a pad remote from the gate electrode. The pad of the other electrode is adapted to be connected directly to the output network to supply a signal to the output network. The remaining electrode is grounded to the ground plane layer.

The spacing between the electrodes and the geometry of the electrodes establishes parasitic shunt capacitances and series inductances that provide substantial matches between the input network and the active region and between the output network and the active region. The lengths of the inactive segments of the gate and other electrode are less than a wavelength of the microwave frequency of the signal supplied to the GaAs microwave field effect transistor. In a preferred embodiment, the lengths of these segments are approximately one-eighth of a wavelength, i.e., in the range of 40 degrees to 50 degrees, of the frequency of the signal being amplified. By providing a substantial impedance match and by minimizing the lengths of the inactive segments of the metal electrodes to less than one wavelength, high power gain and low losses are achieved.

To assist in achieving the desired output power, N active field effect devices are formed on the active layer, where N is an integer greater than one. Each of the active field effect devices includes co-planar spaced source, drain and gate electrodes that cover a single active region. Each pair of adjacent devices shares the same source electrodes, and each pair of adjacent devices share the same drain electrodes. The arrangement is such that: the gate electrode of device K is between the drain and source electrodes of device K, the drain electrodes of devices K and (K-1) are shared, and the source electrodes of devices K and (K+1) are shared, where K equals 2...(N-1). A common gate pad for the N gate electrodes are provided. A common pad is provided for one of the source or drain electrodes of each of the N devices; in the preferred configuration, the common pad is for the drain electrodes. The remaining electrodes of the N devices are connected to the ground plane; in the preferred embodiment, the remaining

0081396

electrodes are the source electrodes. The gate electrodes of the N devices are formed as a continuous stripe that extends between adjacent ones of the devices and is connected at different points to the common gate pad for the N gate electrodes.

According to a further feature, the GaAs FET is arranged in a flip-chip configuration. In the flip-chip configuration, gate, drain and source electrodes metalized on a gallium arsenide pellet have posts plated thereon. The gate and one of the drain or source posts are r spectively bonded to input and output metalized strips plated onto a pair of dielectric layers that cover a copper substrate. A portion of the copper substrate extends between the dielectric layers and is bonded to the remaining posts, in the preferred embodiment the source post. In the preferred embodiment, the posts are gold and the portion of the substrate that extends between the dielectric strips is a gold plating on a copper island of the substrate.

The above and still further objects, features and advantages of the present invention will become apparent upon consideration of the following detailed description of several specific embodiments thereof, especially when taken in conjunction with the accompanying drawings.

BRIEF DESCRIPTION OF THE DRAWING:

Figure 1 is a schematic, topographical view of a single cell of a high power, microwave GaAs FET in accordance with one aspect of the invention;

Figure 2 is a circuit diagram of the GaAs FET illustrated in Figure 1;

Figure 3 is a top view of a GaAs FET employing a plurality of single FET units as illustrated in Figure 1;

Figure 3a is an enlarged view of a portion of the structure illustrated in Figure 3;

Figure 4 is a top view of a 3-cell GaAs FET, wherein each cell includes 18 FET units of the type illustrated in Figure 1;

Figure 4a is a circuit diagram of the device of Figure 4;

Figure 5 is a top view of a flip-chip carrier for the GaAs FET illustrated in Figure 4;

Figure 6 is a sectional view taken through the lines 6-6, Figure 5; and

Figure 7 is a side view taken through the lines 7-7 in each of Figures 4 and 6.

## BEST MODE FOR CARRYING OUT THE INVENTION:

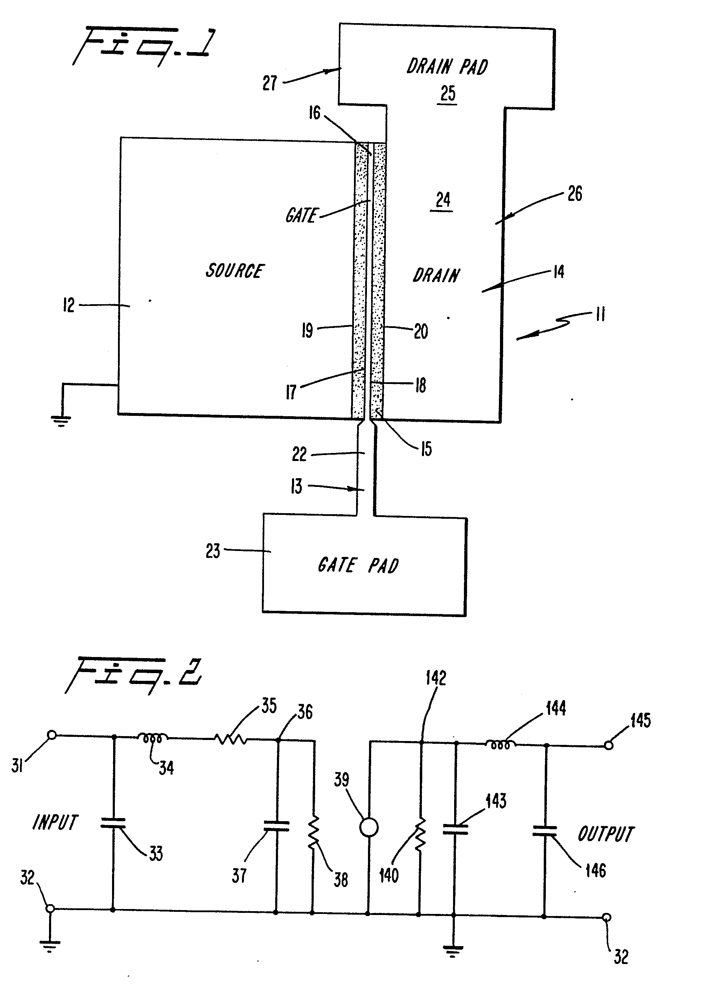

Reference is now made to Figure 1 of the drawing wherein there is illustrated a GaAs FET 11 including grounded, source electrode 12, gate electrode 13, and drain electrode 14. Electrodes 12, 13 and 14 are thin film, co-planar metalized areas that are deposited by any suitable method on intrinsic gallium arsenide active region 15 of FET 11. The portions of electrodes 12, 13 and 14 which cover active region 15 are referred to as the active segments of the electrodes, while the remaining portions of the electrodes are referred to as inactive segments of the electrodes.

Source electrode 12 is formed as a square or rectangle that is connected by a suitable post (not shown in Figure 1) through a dielectric layer (not shown in Figure 1) to a metal substrate (not shown in Figure 1) below active region 15. All of source electrode 12, except the portion thereof connected to the post, covers active region 15. Gate electrode 13 includes an elongated stripe portion 16 having parallel edges 17 and 18 that are also parallel to edges 19 and 20 of electrodes 12 and 14, respectively. Edges 17 and 18 of portion 16 are spaced from edges 19 and 20; portion 16 has a length equal to or slightly greater than the length of edge 19 of electrode 12. Electrode 13 includes stub 22 that is longitudinally aligned with portion 16. Electrode 13 also includes a relatively large area gate pad 23 that is connected to the end of stub 22 remote from elongated portion 16. A network for supplying a microwave signal to be amplified is ohmically connected to gate pad 23, as described infra in the preferred embodiment; typically, the microwave signal has a frequency in the J, K or Ku band and may have a center frequency anywhere from approximately 12 to 16 GHz. The only active segment, coextensive with active region 15 of electrode 13, is elongated portion 16. Stub 22 and pad 23 of electrode 13 are spaced from a metal substrate for FET 11 by a dielectric layer (not shown in Figure 1).

Drain electrode 14 is shaped as a T having elongated leg 24 and arm portion 25 that forms an inactive drain pad. Leg 24 is divided into active and inactive segments 26 and 27, such that the length of active segment 26 is equal to the length of edge 19 of source electrode 12 and of portion 16 of gate electrode 13. Inactive segment 27 connects active segment 26 to pad 25. All of active segment 26 of electrode 14 is coextensive with GaAs active region 15. Inactive segment 27 and drain pad 25 are deposited on a dielectric layer that is deposited on the metal substrate. Drain pad 25 is ohmically connected to an output network which derives a power amplified replica of the microwave signal supplied to gate pad 23.

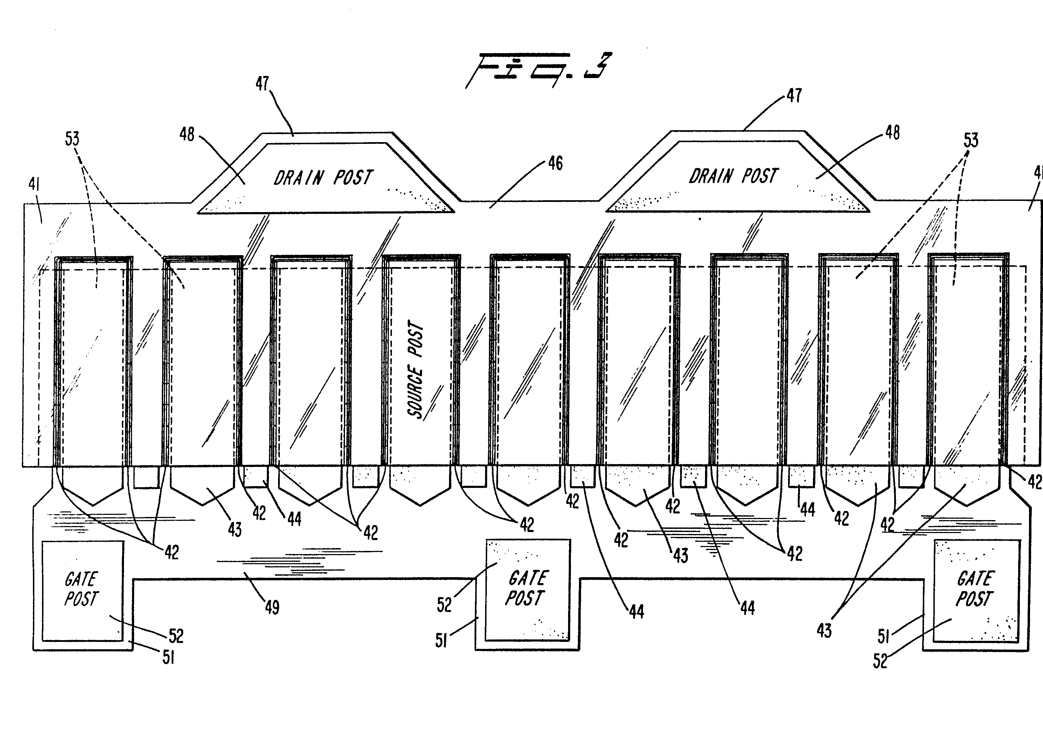

An electrical analysis of the structure of Figure 1 is made by reference to the schematic diagram of Figure 2. The microwave signal applied to gate pad 23 is illustrated in Figure 2 as being applied between signal input terminal 31 and ground terminal 32. The capacitance $(C_{gp})$ of gate pad 23 to the grounded, metal substrate is represented by capacitor 33, connected between terminals 31 and 32. Metalized stub 22, between gate pad 23 and portion 16 of electrode 13, has a substantial inductance

$(L_{gm})$ and a resistance $R_g$, respectively represented by inductance 34 and resistor 35 that are series connected between input terminal 31 and terminal 36. A capacitance $(C_{gs})$ subsists between parallel edges 17 and 19 of electrodes 13 and 12, respectively, and is represented in Figure 2 by capacitor 37, between terminals 36 and 32. The portion of active region 15 between elongated portion 16 of electrode 13 and the grounded metal substrate on which the active region is deposited has a resistive impedance that is represented in Figure 2 by resistor 38, between terminals 36 and 32.

The output circuit of the device of Figure 1 can be represented by current generator 39, shunted by resistor 140, between grounded terminal 32 and terminal 142. Resistor 140 is shunted by a capacitance $(C_{ds})$ represented by capacitor 143; capacitance $C_{ds}$ is established between parallel edges 18 and 20 of portions 16 and 26 of electrodes 13 and 14, respectively. Drain electrode 14 has a substantial inductance $(L_{dm})$ that is represented by a series inductor 144, between terminals 142 and 145, Figure 2. There is also a substantial capacitance $(C_{dp})$ between drain electrode 14 and the grounded metal substrate, as represented by capacitor 146, between terminals 145 and 32.

In a typical high power device, N units of the type described in connection with Figures 1 and 2 are provided, where N is an integer greater than 1; in a preferred embodiment N is equal to 18. The RF voltage applied by gate pad 23 across active region 15 between edges 17 and 19 of each of the N cells modulates each of the active GaAs channels to control the current derived from each of the cells, as represented by current generator 39. Thereby, amplification of the signal applied to gate pad 23 is provided.

The input admittance of a single one of the cells or channels illustrated in Figure 1, excluding the gate pad capacitance $C_{gp}$, can be expressed as:

$$Y_1 = \frac{1}{R_g + j\omega L_{gm} + (\frac{1}{R_c} + j\omega C_{gs})^{-1}}$$

where: $R_g$, $L_{gm}$, $C_{gs}$ are defined supra, $R_c$ = the resistance of the channel, as represented by resistor 38, and $\omega$ = angular frequency of the microwave signal applied to pad 23.

For a composite FET with N channels, of the type illustrated in Figure 1, connected in parallel so that each of the N channels shares a single gate pad, the input admittance is:

$$Y_{in} = j\omega C_{gp} + NY_1$$

As described in detail infra, it is possible to provide a single gate pad in such a configuration by providing a single stripe for each gate portion 16 of the N channels that form a composite cell.

In the present invention, the size of gate pad 23, and hence the value of capacitance $C_{gp}$ (capacitor 33) is designed as a part of a matching network for the microwave source connected to terminal 31. This is in contrast with the typical prior art wherein the gate pad capacitance $C_{gp}$ (capacitor 33) is generally fixed because of the fixed, relatively small area of the gate bonding pad; in the typical prior art configuration, the gate bonding pad has an area of approximately 3 X 3 mils. In the present invention, the gate inactive segment geometry, i.e., area and topographical configuration of gate pad 23 and stub 22, and the spacing between edges 17 and 19 are designed such that the gate source capacitance (capacitor 37), gate pad capacitance (capacitor 33) and gate pad inductance (inductor 34) obviate the need for an external matching network to be connected to the input network containing the microwave source which is, in turn, connected to terminal 31. The spacing between edges 18 and 20, as well as the geometry of drain electrode 14, is such that inductor 144 as well as capacitors 143 and 146 obviate the need for an external matching network between terminals 145 and 32 and the output network connected to a terminal of a load.

Thus, the present invention provides a departure from the prior art situation wherein there is usually some inductance and resistance, introduced by bond wire and a package in series with the input and output admittances of the GaAs FET. In the prior art, therefore; a substantial portion of the microwave voltage is dissipated across the series inductance and resistance of the bonding wire and the package. This voltage drop across the parasitic impedance established by the bonding wire and package is especially severe for high frequency (above 16 GHz) and high power (above 2 watts) GaAs FET's.

As described in detail infra, N of the channels illustrated in Figure 1 are connected to a single gate pad 23 and to a single drain pad 25 in such a way that there is no need for any bond wire and so that the length of the inactive segments is minimized. By connecting portion 16 of the several channels in series with each other, by a single continuous stripe, matching is achieved to the N low power FET channels before power combination. This approach has three major advantages:

(a) losses due to parasitic impedance are virtually eliminated because there are virtually no unwanted parasitic impedances;

**0081396**

(b)   the band width of the GaAs FET is greatly improved because impedance matching exists at the terminal of the active channel, such that there is only a relatively short electric length (less than one wavelength) of the inactive segments between the active region and the input and output networks connected to the pads; and

(c)   loss in the matching networks formed by the electrodes is minimized because the individual low power unit cells, which have relatively high impedances, are matched, prior to being connected together.

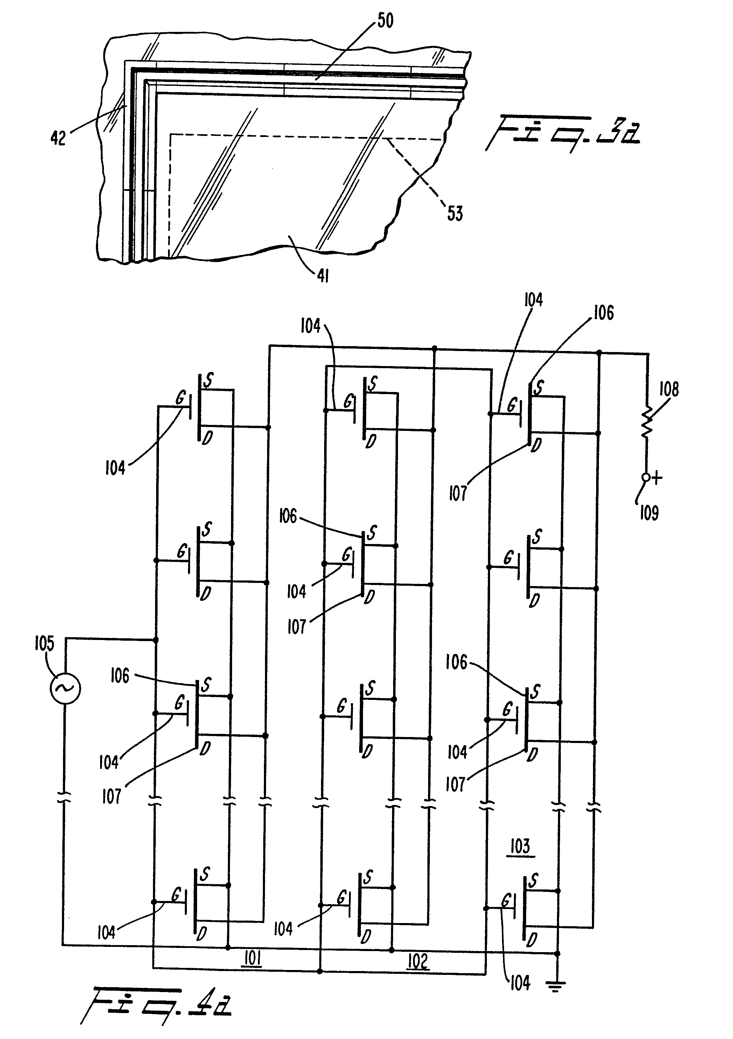

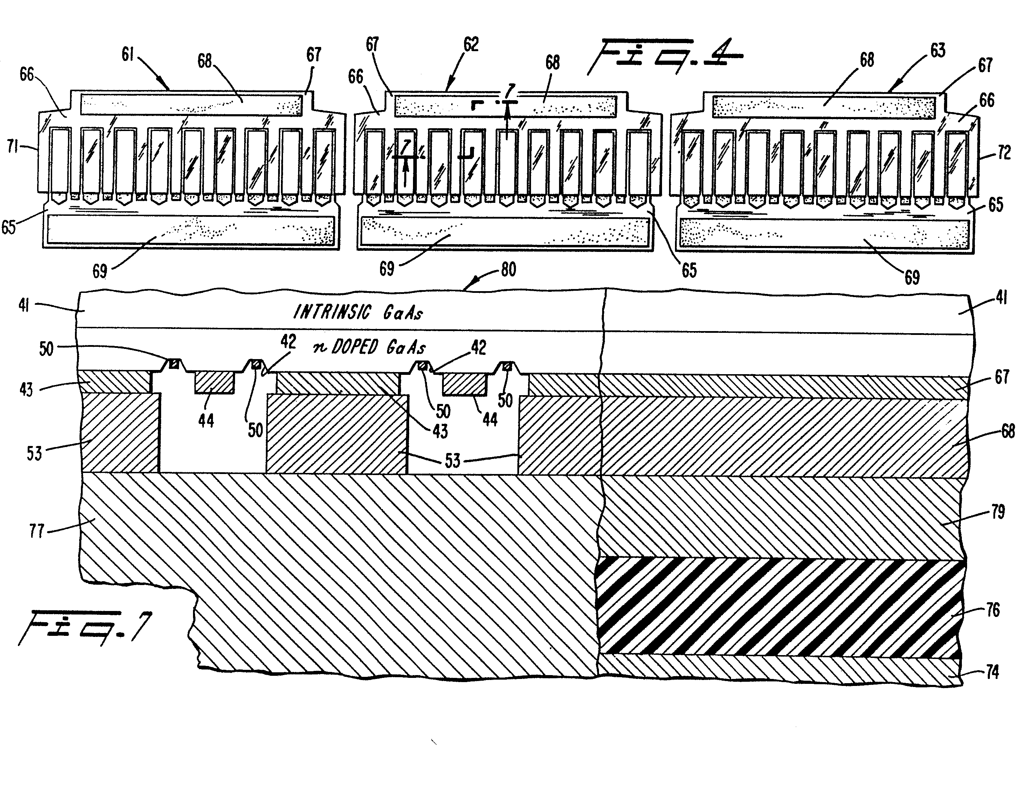

Reference is now made to Figure 3 of the drawing, a top view of an 18 cell GaAs FET mounted on an internally matched carrier. The specific structure illustrated in Figure 3 is designed to derive a 3.5 watt output signal  in the microwave J band.  Dimensions for the electrodes for such an output are indicated infra. To achieve the 3.5 watt output, three of the devices illustrated in Figure 3 are combined in side by side relationship, similar to that described infra in connection with Figure 4.

The structure of Figure 3 includes an active gallium arsenide rectangular slab 41 that is superimposed on eighteen different field effect channels to define the active regions of eighteen parallel field effect devices. The eighteen different channels 42 are illustrated in Figure 3 as spaced regions between the active segments of the source and drain electrodes. The same electrodes of the 18 devices are formed as nine metal fingers 43 that are interdigitated with ten metal fingers 44 that form the drain electrodes for the 18 devices; channels 42 are located between and spaced from the interdigitated fingers. In actuality each of channels 42 is configured in the same manner as the channel of Figure 1, i.e., each of channels 42 includes an elongated portion, similar to elongated portion 16 of gate electrode 13.  The elongated portion in each of channels 42 includes a pair of parallel edges spaced from parallel edges of fingers 43 and 44 which are adjacent to it. Thus, each of the 18 FET cells illustrated in Figure 3 is arranged so that it shares a portion of its source with a first adjacent cell. Each of the 18 FET cells also shares a portion of its drain with a second adjacent cell. Thus, if N (where N is an integer greater than 1) cells are provided, the drains of cells K and K-1 are shared and the sources of cells K and K+1 are shared. The drain electrode is thus formed as $\frac{N+2}{2}$ elongated fingers 44 that are interdigitated with $\frac{N}{2}$ elongated fingers 43 that form the source electrode.

Interdigitated drain fingers 44 are integral with and have a common connection to elongated metal strip 46 that extends completely along the length of the composite 18 cell FET. Strip 46 includes two spaced trapezoidal tabs 47 equispaced from the ends of the composite FET and from the center of the composite FET. Plated on tabs 47 are metal drain posts 48, each having a trapezoidal shape, and preferably formed of a highly electrically conductive, inert material, such as gold. Drain posts 48 connect tabs 47 to the load via a conductive output network connected directly to the posts.

Extending along the side of the composite FET opposite from strip 46 is an elongated metalized gate strip 49 that is an integral part of the continuous gate stripe that extends between fingers 43 and 44; thus the gate stripe is connected to strip 49 at the root of each fingers 43. The metalized gate pad includes three rectangular tabs 51, two of which are at opposite ends of the strip; the remaining rectangular tab is in the center of the strip. Extending from each of tabs 51 is a highly conductive, chemically inert metal post 52, preferably formed of gold. Posts 52 are connected to the input network which supplies the signal to be amplified to the composite FET. An integral part of the gate electrode includes a continuous stripe, such as gate portion 16 (Figure 1) that extends throughout the length of stripe 42. The metal strip that extends in stripe 42 and which is a part of the gate pad thereby has a continuous current pad parallel to and not contacting the lengths of the interdigitated source and drain fingers 43 and 44, as well as between and not contacting the interdigitated fingers, parallel to the roots or tips thereof. Thus, there is a continuous metal gate portion 50, Figure 3a, completely surrounding each of source fingers 43. The metal portion of the gate, of course, is spaced from the fingers of the source pad to provide the necessary capacitive coupling between the source and gate pads.

In an actually constructed device, as illustrated in Figure 3, the structure on which the electrode structure is mounted is 707 micrometers in length and 400 micrometers in width. Each of the interdigitated fingers 43 and 44 has a length of 150 micrometers. There is a spacing of 50 micrometers across each finger 43, between opposite, parallel edges of stripe 42, and a distance of 23 micrometers between opposite, remote edges of stripe 42 across interdigitated fingers 44. With such dimensions, the distance between the inactive segments connected to gate posts 52 and the active segments above slab 41 is 40 degrees at a wavelength of 14 GHz, to establish a characteristic impedance of 16 ohms. The distance between the network connected to drain post 48 and the interdigitated fingers 44 is 50 degrees at 14 GHz, to establish a characteristic impedance of 20 ohms. While 16 and 20 ohm impedances do not provide exact matching between 50 ohm sources and loads to the GaAs FET, the mismatch is considerably less than the match which typically exists in the prior art, wherein the input and output impedances of the GaAs FET are on the order of two to three ohms.

The power gain of the device illustrated in Figure 3 and the stated dimensional parameters extended from 8.6 dB at a frequency of 16 GHz to a gain of 12.3 dB, at a frequency of 12.5 GHz.

The interdigitated fingers 43 are connected to a grounded, highly conductive, metal substrate, preferably copper, by gold posts 53. One of posts 53 is provided for each of the interdigitated fingers 43. Post 53 is preferably deposited by thin film or other techniques on the substrate and bonded to the pads by utilizing known techniques.

Reference is now made to Figure 4 of the drawing wherein three composite units 61, 62 and 63, each similar to the unit illustrated in Figure 3, are illustrated in side by side relationship. The device of Figure 4 is constructed for a 3.5 watt output in the Ku-band. Each of units 61, 62 and 63 includes 18 GaAs FET channels, interconnected together in a manner similar to the composite unit illustrated in Figure 3. Each of units 61-63, however, differs from the unit illustrated in Figure 3 because the units in Figure 4 do not include drain and gate tabs 47 and 51. In all other respects, including dimensions and geometry of the interdigitated fingers and the continuous metallic stripe of the gate electrode for each of cells 61-63, the cells of Figure 3 and 4 are the same.

Figure 4a, a circuit diagram of the structure illustrated in Figure 4, includes three parallel banks 101, 102 and 103 of a like number (18 in the illustrated embodiment) of parallel microwave FETs, respectively representing the devices on composite units 61, 62 and 63. Each of banks 101, 102 and 103 includes multiple, parallel gate electrodes 104 responsive to microwave source 105, multiple grounded source electrodes 106 and multiple drain electrodes 107 connected in parallel to microwave load 108, in turn connected to a positive D.C. power supply terminal 109.

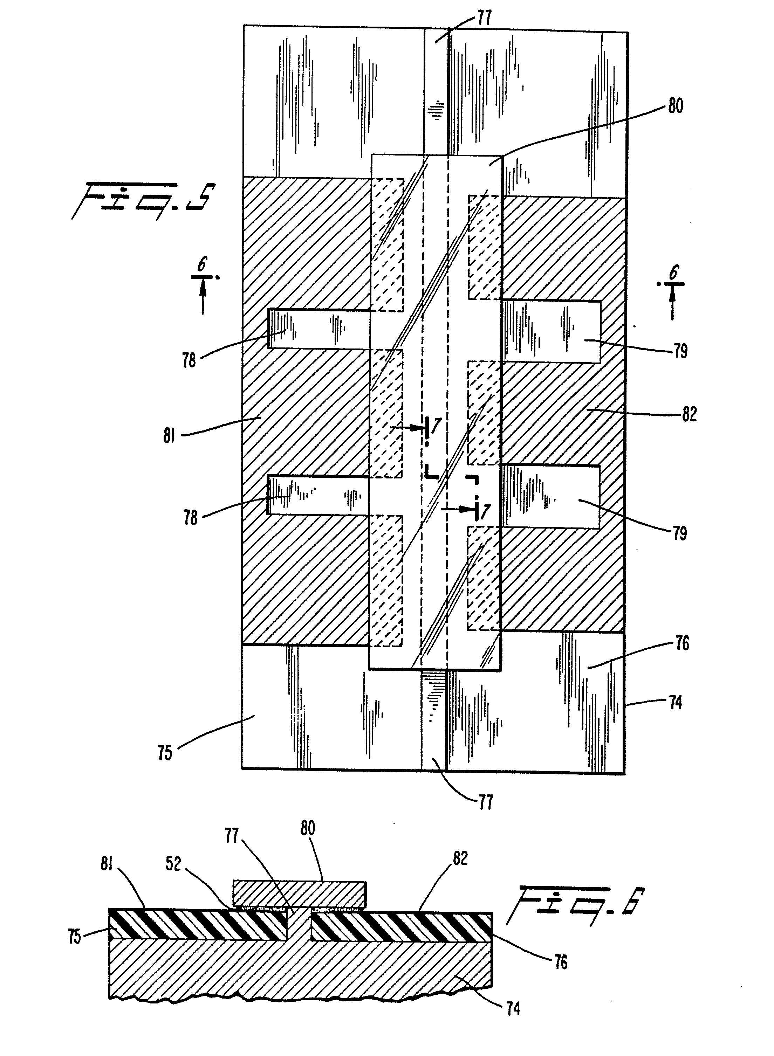

The gate and drain electrodes in each of units 61-63 respectively include elongated strips 65 and 66 on opposite sides of a pellet forming the composite, 18 channel unit. As illustrated in Figures 4 and 7, the drain includes an elongated tab 67 that extends from strip 66 that is connected to the interdigitated fingers. Tab 67 carries a single elongated, highly conductive, chemically inert drain post 68, while elongated, highly conductive, chemically inert gate post 69 is carried by strip 65. Source posts extend from the source fingers in each of units 61-63 in the same manner described in connection with Figure 3. Gate and drain strips 65 and 66 have lengths of 650 micrometers and 600 micrometers, respectively.

The co-planar gate, source and drain electrodes of cells 61-63 are plated on a common GaAs pellet 80 (Figures 5, 6 and 7) that extends from edge 71 of unit 61 to edge 72 of unit 63, across the interdigitated source and drain fingers of units 61-63. As illustrated in Figures 5, 6 and 7, pellet 80 is mounted in a flip-chip configuration, whereby the pellet face remote from the source, drain and gate electrodes is remote from metallic, preferably copper, substrate 74. Plated onto the upper face of substrate 74 are spaced dielectric films 75 and 76, between which extends upwardly extending island 77 of copper substrate 74. The upper edge of island 77 is gold plated (not shown) and bonded to source posts 53, in turn coated on fingers 43. Figure 7 also clearly shows the positioning of gate 50 between source and drain fingers 43 and 44.

Dielectric strip 75 carries metallic pattern 81 with un-metalized areas 78. The metallic pattern 81 is designed as a distributed microwave circuit to further match the impedance of the FET chip to the microwave source and the load impedance of 50 ohms. The microwave signal to be amplified is applied to pattern 81. Coated on dielectric layer 76 is metalization pattern 82 leaving an un-metlized area 79. Pattern 82 supplies the amplified signal to a load. The gate posts 68 and the drive posts 68 (Figure 4) are connected to metal patterns 81 and 82, respectively, by a proper scheme such as a theraml compression bond. The longitudinal axes of the patterns 81 and 82 are aligned and spaced one third from the edges of the gallium arsenide pellet on which the electrodes illustrated in Figure 4 are mounted. Tabs within pattern 81 have a width enabling each of them to be bridged to and be connected to post 69 of an adjacent pair of cells 61 and 62 or of post 69 of cells 62 and 63. Similarly, tabs 82 have a width enabling them to be bridged to and connected to post 68 of a pair of adjacent cells 61 and 62 or of post 68 of a pair of adjacent cells 62 and 63. Thereby, an ohmic connection is established for the microwave source connected to pattern 81 and to gate strip 65 of units 61-63 by way of gate post 69 of the three units, and ohmic connections are established between drain pads 66 of units 61-63 to the load connected to pattern 82 by way of drain post 68 of the three units.

The three cell pellet illustrated in Figure 4 and mounted on substrate 74 has a length of approximately 2.54 millimeters and a width of 0.6 millimeters. Each of units 61-63 is dimensioned so that at 16 GHz, there is a distance of approximately 40 degrees between the gate post and the active region, and a distance of approximately 50 degrees between the interdigitated fingers and drain post 68. The flip-chip configuration of Figures 5 and 6 enables units 61-63 to be connected in parallel with the microwave source and the load. Because individual cells 61-63 are impedance matched before being combined in a three cell pellet, the impedance of the 3.5 watt GaAs FET device remains reasonably high and can be matched to 50 ohm sources and loads without excessive loss.

While there have been described and illustrated several specific embodiments of the invention, it will be clear that variations in the details of the embodiment specifically illustrated and described may be made without departing from the true spirit and scope of the invention as defined in the appended claims.

CLAIMS:

1.  A microwave field effect transistor having electrodes substantially matched to external input and output networks comprising a metal ground plane layer, dielectric means, a gallium arsenide active region, substantailly co-planar spaced source, gate and drain electrodes having active and inactive segments respectively contacting  the active region and the dielectric means, the active segment of the gate electrode being located between the active segments of the source and drain electrodes, one of the drain and source electrodes being connected to the ground plane layer, the inactive segments of the gate electrode and of the other electrode being respectively connected directly to the input and output networks, the active region having an impedance between the gate electrode and the one electrode substantially less than the impedance of the input network, the active region having an impedance between the other electrode and the ground plane substantially less than the impedance of the output network, the geometry and spacing of the electrodes establishing parasitic shunt capacitances and series inductances that provide substantial matches between the input network and the active region and between the active region and the output network, the lengths of the inactive segments of the gate and the other electrodes having lengths less than a wavelength of a microwave signal applied to the gate electrode by the input network.

2.  The transistor of claim 1 wherein N of said field effect transistors are provided on the ground plane layer; where N is an integer greater than one, the inactive segments of the N gate electrodes and of the other electrodes being connected in parallel to the input and output networks, respectively.

3. The transistor of claim 2 wherein the inactive segments of the gate electrodes of the N transistors are connected together to a first single inactive metal strip, and the inactive segments of the other electrode are connected to a second single inactive metal strip, first and second metal posts respectively extending from the first and second strips to provide contacts directly to the input and output networks, N third metal posts directly connected to the one electrode of each of the N transistors and to the ground plane, respectively, said first, second and third posts extending in the same direction from the active region toward the ground plane, the input and output networks being metal strips on a dielectric layer carried by the ground plane, the metal strips and the ground plane being insulated from each other by the dielectric layer.

4. The transistor of claim 3 wherein the electrodes are carried by a first face of the active region so they face the dielectric layer and the substrate, the active region including a second face opposite from the first face and remote from the electrodes, whereby the field effect transistors are arranged in a flip-chip configuration.

5. The transistor of claims 2, 3 or 4 wherein the active segment of the gate electrodes for the N transistors comprises a single continuous stripe connected at different points to the inactive segments of the N transistors.

6. A microwave field effect transistor having electrodes adapted to be connected to external input and output networks comprising a metal ground plane layer, dielectric layer means on the ground plane layer, an active region on the dielectric layer means, N field effect devices being formed on the active layer, where N is an integer greater than one, each of the devices including: co-planar, spaced source, drain and gate electrodes on a face of the active region; each pair of adjacent devices sharing the same source electrodes; each pair of adjacent devices sharing the same drain electrodes; whereby the gate electrode of device K is between the drain and source electrodes of device K, the drain electrodes of devices K and (K-1) are shared, and the source electrodes of devices K and (K+1) are shared, where K=2...(N-1); a common gate pad for the N gate electrodes; a common pad for another electrode of each of the N devices; the remaining electrodes of the N devices being connected to the ground plane; the gate electrodes for the N devices being a continuous stripe extending between adjacent ones of the devices and connected at different points to the common gate pad for the N gate electrodes.

7. The transistor of claim 6 wherein the source electrodes of devices K and (K+1) are formed as parts of first and second fingers interdigitated with a third finger forming the drain electrodes of devices K and (K+1).

8. The transistor of claim 7 wherein each electrode of each device includes an active segment contacting the active region and an inactive segment that does not overlay the active region, wherein the inactive segments of the gate electrodes of the N transistors are connected together to a first single inactive metal strip, and the inactive segments of the other electrode are connected to a second single inactive metal strip, first and second metal posts respectively extending from the first and second strips to provide contacts directly to the input and output networks, N third metal posts directly connected to the one electrode of each of the N transistors and to the ground plane, respectively, said first, second and third posts extending in the same direction from the active region toward the ground plane, the input and output networks being metal strips on a dielectric layer carried by the ground plane, the metal strips and the ground plane being insulated from each other by the dielectric layer.

9.  The transistor of claim 8 wherein the electrodes are carried by a first face of the active region so they face the dielectric layer and the substrate, the active region including a second face opposite from the first face and remote from the electrodes, whereby the field effect transistors are arranged in a flip-chip configuration.

10.  The transistor of claims 6, 7, 8 or 9 wherein the active region has an impedance between the gate electrode and the one electrode substantially less than the impedance of the input network, the active region having an impedance between the other electrode and the ground plane substantially less than the impedance of the output network, the geometry and spacing of the electrodes establishing parasitic shunt capacitances and series inductances that provide substantial matches between the input network and the active region and between the active region and the output network, the lengths of the inactive segments of the gate and the other electrodes having lengths less than a wavelength of a microwave signal applied to the gate electrode by the input network.

*Fig.1*

DRAIN PAD
25

27

16

GATE

24

SOURCE

12

DRAIN

26

14

11

19          20

17          18

15

22

13

23          GATE PAD

*Fig.2*

35    36          142          144          145

34                      39

31

INPUT

33              37    38    140    143    146    OUTPUT

32                                          32

FIG. 3

DRAIN POST

DRAIN POST

SOURCE POST

GATE POST

GATE POST

GATE POST

0081396

Fig.3a

Fig.4a

FIG. 4

FIG. 7

INTRINSIC GaAs

n DOPED GaAs

4/5

0081396

FIG.5

FIG.6